# EUROPÄISCHE PATENTANMELDUNG

(11) **EP 4 779 417 A1**
(43) Veröffentlichungstag der Anmeldung: **22.07.2026**
(21) Anmeldenummer: 25215591.6
(22) Anmeldetag: 13.11.2025
(51) Int. Cl.: G05B 19/042, H03K 17/96

(54) **FELDGERÄT FÜR EINE INDUSTRIEANLAGE**

(30) Priorität: 20.01.2025 DE 102025101807
(71) Anmelder: Murrelektronik GmbH, 71570 Oppenweiler (DE)
(72) Erfinder: Lang, Rudolf, 71570 Oppenweiler (DE); Riedel, Steffen, 71570 Oppenweiler (DE); Setzer, Timo, 71570 Oppenweiler (DE)
(74) Vertreter: Prinz & Partner mbB

(57) **Zusammenfassung**

Ein Feldgerät (10) für eine Industrieanlage umfasst wenigstens ein kapazitives Bedienelement (30), mit dem ein Betriebsmodus des Feldgeräts (10) einstellbar ist, und einen Prozessor (32), der mit dem wenigstens einen kapazitiven Bedienelement (30) gekoppelt ist. Der Prozessor (32) ist dazu eingerichtet, eine Bedienung des kapazitiven Bedienelements (30) nur dann umzusetzen, wenn eine Freigabe erfolgt ist, die auf einem Betätigungsmuster oder einem externen Freigabesignal basiert. Ferner wird ein Verfahren zum Einstellen eines Betriebsmodus eines Feldgeräts (10) beschrieben.

## Beschreibung

Die Erfindung betrifft ein Feldgerät für eine Industrieanlage und ein Verfahren zum Einstellen eines Betriebsmodus eines Feldgeräts.

In modernen Maschinen und/oder Anlagen werden häufig eine Vielzahl elektronischer Geräte verbaut, beispielsweise Sensoren oder Aktuatoren, die über Feldgeräte angesteuert werden.

Viele klassische Feldgeräte weisen Bedienelemente zum Einstellen von Parametern auf, zum Beispiel Schalter oder Taster. Zur Realisierung derartiger Bedienelemente werden typischerweise Durchbrüche in das Gehäuse des Feldgeräts eingebracht, die dann mit dem jeweiligen Bedienelement sowie speziellen Dichtungen zumindest teilweise verschlossen werden. Um zu verhindern, dass Fremdkörper oder Flüssigkeiten durch die Durchbrüche in das Gehäuseinnere gelangen, ist typischerweise eine Abdichtung im Bereich des jeweiligen Bedienelements vorgesehen.

Der Einbau und die Abdichtung sind zumeist technisch aufwendig und teuer. Außerdem können die Dichtungen durch Verschleiß, Alterung oder unsachgemäße Handhabungen versagen, was wiederum dazu führt, dass die im Inneren des Gehäuses angeordneten elektronischen Komponenten nicht mehr ausreichend vor Umwelteinflüssen geschützt sind. Darüber hinaus kann es durch Defekte an den jeweiligen Bedienelementen und/oder unsachgemäßer Handhabung zu Fehlbedienungen kommen.

Die Aufgabe der Erfindung ist es daher, die aus dem Stand der Technik bekannten Nachteile zu überwinden und ein einfach bedienbares sowie robustes Feldgerät bereitzustellen, welches zudem kostengünstig herstellbar ist.

Die Aufgabe wird erfindungsgemäß gelöst durch ein Feldgerät für eine Industrieanlage, umfassend wenigstens ein kapazitives Bedienelement, mit dem ein Betriebsmodus des Feldgeräts einstellbar ist. Das Feldgerät weist einen Prozessor auf, der mit dem wenigstens einen kapazitiven Bedienelement gekoppelt ist, und der dazu eingerichtet ist, eine Bedienung des kapazitiven Bedienelements nur dann umzusetzen, wenn eine Freigabe erfolgt ist, die auf einem Betätigungsmuster oder einem externen Freigabesignal basiert.

Der Grundgedanke der Erfindung ist es, Betriebsmoduseinstellungen am Feldgerät mittels des kapazitiven Bedienelements vorzunehmen. Dieses kann durch die Gehäusewand des Feldgerätes bedient werden, beispielsweise indem ein Nutzer die Gehäusewand berührt. Durchbrüche im Gehäuse, welche den Schutz der innenliegenden Elektronik reduzieren, können so vermieden werden. Auch ist es daher nicht notwendig, dass Dichtungen vorgesehen sind, wodurch die Feldgeräte entsprechend kostengünstig hergestellt werden können. Gleichzeitig wird sichergestellt, dass es nicht zu Fehlbedienungen oder unerwünschten Zugriffen auf das Feldgerät kommt, indem die Bedienung nur dann umgesetzt wird, wenn eine entsprechende Freigabe erfolgt ist.

In einer Variante sind alle Bedienelemente des Feldgeräts als kapazitive Bedienelemente ausgebildet und innerhalb des Gehäuses so angeordnet, dass sie durch eine Wand des Gehäuses von außen durch einen Nutzer manuell betätigbar sind. Mit anderen Worten weist das Feldgerät also keinerlei (mechanische) Bedienelemente auf, die über Gehäuseöffnungen an die innenliegende Elektronik angebunden sind, wie beispielsweise Schalter oder Tasten, oder zu deren Bedienung eine Öffnung des Gehäuses erforderlich ist, beispielsweise über eine Serviceklappe.

Denkbar ist auch, dass das Feldgerät lediglich ein einziges kapazitives Bedienelement aufweist, mit dem insbesondere ein Werksreset durchgeführt werden kann, also das Feldgerät in einen initialen Betriebsmodus zurückversetzt werden kann. Fehlerhafte Einstellungen am Feldgerät können so einfach und zuverlässig behoben werden.

In einer Ausführungsvariante umfasst das wenigstens eine kapazitive Bedienelement zwei kapazitive Bereiche, die an verschiedenen Seiten des Feldgeräts angeordnet sind. Insbesondere sind die zwei kapazitiven Bereiche an entgegengesetzten Seiten des Feldgeräts angeordnet. Dadurch, dass zwei räumlich voneinander beabstandete kapazitive Bereiche zur Einstellung des Betriebsmodus genutzt werden, kann das Risiko von unbeabsichtigten Eingaben durch versehentliches Berühren des Feldgeräts verringert werden.

Zum Beispiel weist das Feldgerät eine Anschlussseite, eine erste Längsseite, eine zweite Längsseite, eine erste Stirnseite und eine zweite Stirnseite auf, wobei einer der beiden kapazitiven Bereiche an der ersten Längsseite des Feldgeräts angeordnet ist und wobei der andere der beiden kapazitiven Bereiche an der zweiten Längsseite des Feldgeräts angeordnet ist.

Es hat sich gezeigt, dass diese Anordnung eine ergonomisch besonders einfache Bedienung des Feldgeräts ermöglicht. Beispielsweise kann ein Nutzer das Feldgerät mit einer Hand umgreifen und so die beiden an den Längsseiten angeordneten kapazitiven Bereiche gleichzeitig mit verschiedenen Fingern der Hand erreichen und betätigen, insbesondere dem Daumen und einem anderen Finger wie dem Zeige- oder Mittelfinger.

In diesem Zusammenhang ist auch denkbar, dass das Feldgerät eine maximale Breite aufweist, die ein Umgreifen mit einer Hand ermöglicht. Beispielsweise beträgt die maximale Breite und/oder der maximale Abstand der beiden kapazitiven Bereiche zueinander höchstens 15 cm, vorzugsweise höchstens 10 cm, besonders bevorzugt höchstens 7 cm.

Grundsätzlich kann eine gleichzeitige Berührung des ersten kapazitiven Bereichs und des zweiten kapazitiven Bereichs ein Betätigungsmuster darstellen. Ferner ist es denkbar, dass mit dem gleichzeitigen Berühren gleichzeitig sowohl die Freigabe als auch die Bedienung erfolgt. Mit anderen Worten kann sowohl die Eingabe als auch die Freigabe durch den Nutzer zur gleichen Zeit erfolgen. Dies ermöglicht eine sehr einfache und zeiteffiziente Bedienung.

Es kann aber auch eine andere zeitliche Abfolge, also anders als gleichzeitig, als Betätigungsmuster vorgesehen sein, bspw. eine Berührung des ersten kapazitiven Bereichs für eine definierte Dauer, bspw. zwei Sekunden, wodurch erst eine Berührung des zweiten kapazitiven Bereichs erfasst bzw. freigeschaltet werden würde.

Grundsätzlich kann als Betätigungsmuster also eine zeitlich verteilte Eingabe über zumindest einen kapazitiven Bereich des Bedienelements oder über ein vom Feldgerät umfasstes kapazitives Freigabeelement vorgesehen sein. Beispielsweise kann ein Nutzer das zur Freigabe nötige Betätigungsmuster eingeben, indem er einen oder mehrere kapazitive Bereiche des Betätigungselements oder (falls vorhanden) das kapazitive Freigabeelement für eine bestimmte Zeitdauer und/oder wiederholt berührt.

Gemäß einem Aspekt ist als Betätigungsmuster ein zumindest zweimaliges Antippen zumindest eines kapazitiven Bereichs des Betätigungselements oder (falls vorhanden) des kapazitiven Freigabeelements vorgesehen.

In einer weiteren Variante ist vorgesehen, dass das Feldgerät ein Ausgabeelement zum Ausgeben eines Signals aufweist, welches dem Nutzer das Betätigungsmuster vorgibt. Beispielsweise ist das Ausgabeelement ein optischer Signalgeber, der dazu ausgebildet ist, ein Lichtsignal an dem Ort auszugeben, an dem das kapazitive Bedienelement angeordnet ist. Insbesondere kann der optische Signalgeber eine oder mehrere innerhalb des Gehäuses des Feldgeräts angeordnete Lichtquellen umfassen, die Licht so aussenden können, dass es im Bereich des kapazitiven Bedienelements durch die Gehäusewand nach außen gelangen und von einem Nutzer wahrgenommen werden kann. Das Gehäuse kann zu diesem Zweck zumindest teilweise transparent ausgebildet sein. Durchbrüche im Gehäuse sind zur Ausgabe des Signals also nicht erforderlich.

Selbstverständlich können bei einer Ausgestaltung mit zwei an entgegengesetzten Seiten des Feldgeräts angeordneten kapazitiven Bereichen auch mehrere Lichtquellen und/oder Lichtleiter vorgesehen sein, um Signalausgaben bei den jeweiligen kapazitiven Bereichen, also an den entgegengesetzten Seiten des Feldgeräts, zu ermöglichen.

Beispielsweise werden mit dem Signal Eingabevorgaben für einen Nutzer ausgegeben. Konkret kann mittels des optischen Signalgebers zum Beispiel ein Blinkmuster erzeugt werden, welches dem Nutzer vorgibt, in welchen zeitlichen Abständen der Nutzer einen bestimmten kapazitiven Bereich berühren muss, um eine Eingabe zu machen und/oder freizugeben. In diesem Fall erfolgt also eine Bedienung des wenigstens einen kapazitiven Bedienelements gemäß dem vom Ausgabeelement ausgegebenen Betätigungsmuster. Dies vereinfacht die Bedienung und verringert das Risiko von Falscheingaben.

Alternativ oder zusätzlich zu einer Freigabe durch den Nutzer selbst ist es auch möglich, dass die Freigabe durch ein externes Freigabesignal erfolgt. Das externe Freigabesignal kann beispielsweise ein Funksignal oder ein über eine Versorgungsleitung des Feldgeräts empfangenes Signal sein. Denkbar ist auch, dass das externe Freigabesignal ein elektrisches Signal ist, mit dem das Feldgerät bei einer Inbetriebnahme aktiviert wird. Zum Beispiel kann das Freigabesignal dadurch vorgegeben werden, dass das Feldgerät an eine Stromversorgung angeschlossen und dadurch in Betrieb genommen wird.

In einer Variante ist das kapazitive Bedienelement und/oder der Prozessor dazu ausgebildet, eine Einstellung des Betriebsmodus des Feldgeräts nur innerhalb eines vorgegebenen Zeitraums nach einer Inbetriebnahme des Feldgeräts zuzulassen. Wenn also zum Beispiel zu einem bestimmten Zeitpunkt ein Freigabesignal durch den Anschluss des Feldgeräts an eine Stromversorgung erfolgt, so können Eingaben ab diesem Zeitpunkt nur innerhalb des vorgegebenen Zeitraums vorgenommen werden. Der vorgegebene Zeitraum beträgt beispielsweise maximal 15 Minuten, vorzugsweise maximal 1 Minute, besonders bevorzugt maximal 10 Sekunden. Dadurch kann das Risiko von Eingaben durch unberechtigte Nutzer reduziert und somit die Betriebssicherheit insgesamt erhöht werden.

Um die Betriebssicherheit weiter zu erhöhen, kann außerdem vorgesehen sein, dass der Prozessor dazu eingerichtet ist, eine Einstellung des Betriebsmodus des Feldgeräts nur dann zuzulassen, wenn mehrere voneinander unabhängige Freigabebedingungen erfüllt sind. Beispielsweise kann die bereits erwähnte Eingabe innerhalb des vorgegebenen Zeitraums nach einer Inbetriebnahme des Feldgeräts eine erste Freigabebedingung und die Betätigung des kapazitiven Bedienelements mittels eines vorgegebenen Bedienmusters eine zweite Freigabebedingung sein, die zur Umsetzung der Bedienung beide erfüllt sein müssen.

In einer weiteren Variante umfasst das Feldgerät ein kapazitives Freigabeelement, das dazu ausgebildet ist, das kapazitive Bedienelement freizugeben. Mit anderen Worten können das Einstellen des Betriebsmodus einerseits und die Freigabe andererseits durch zwei separate kapazitive Elemente realisiert werden. Diese Aufteilung hat sich als technisch einfach umsetzbar und besonders fehlerunanfällig erwiesen.

Die Aufgabe der Erfindung wird ferner gelöst durch ein Verfahren zum Einstellen eines Betriebsmodus eines Feldgeräts, das wenigstens ein kapazitives Bedienelement aufweist. Das Verfahren umfasst zumindest die Schritte: Erfassen einer Freigabe, die aufgrund eines Betätigungsmusters des wenigstens einen kapazitiven Bedienelements oder eines externen Freigabesignals erfolgt; und Umsetzen einer Bedienung des kapazitiven Bedienelements nur dann, wenn zuvor die Freigabe erfasst worden ist.

Die Vorteile, die zum erfindungsgemäßen Feldgerät diskutiert wurden, gelten für das Verfahren in gleicher Weise.

In einer Variante des Verfahrens ist vorgesehen, dass das Betätigungsmuster eine gleichzeitige Betätigung von wenigstens zwei kapazitiven Bereichen des wenigstens einen kapazitiven Bedienelements oder eine Betätigung des wenigstens einen kapazitiven Bedienelements in einer definierten zeitlichen Folge ist. Durch diese Umsetzung des Betätigungsmusters können unbeabsichtigte Fehlbedienungen oder unerwünschten Zugriffe auf das Feldgerät durch unberechtigte Nutzer besonders zuverlässig verhindert werden.

Weitere Merkmale und Vorteile der Erfindung ergeben sich aus der nachfolgenden Beschreibung sowie aus den Zeichnungen, auf die Bezug genommen wird. **In** den Zeichnungen zeigen:
- Fig. 1 eine schematische Darstellung eines erfindungsgemäßen Feldgeräts gemäß einer ersten beispielhaften Ausführungsform;
- Fig. 2 eine schematische Darstellung eines erfindungsgemäßen Feldgeräts gemäß einer zweiten beispielhaften Ausführungsform; und
- Fig. 3 eine schematische Darstellung eines erfindungsgemäßen Feldgeräts gemäß einer dritten beispielhaften Ausführungsform.

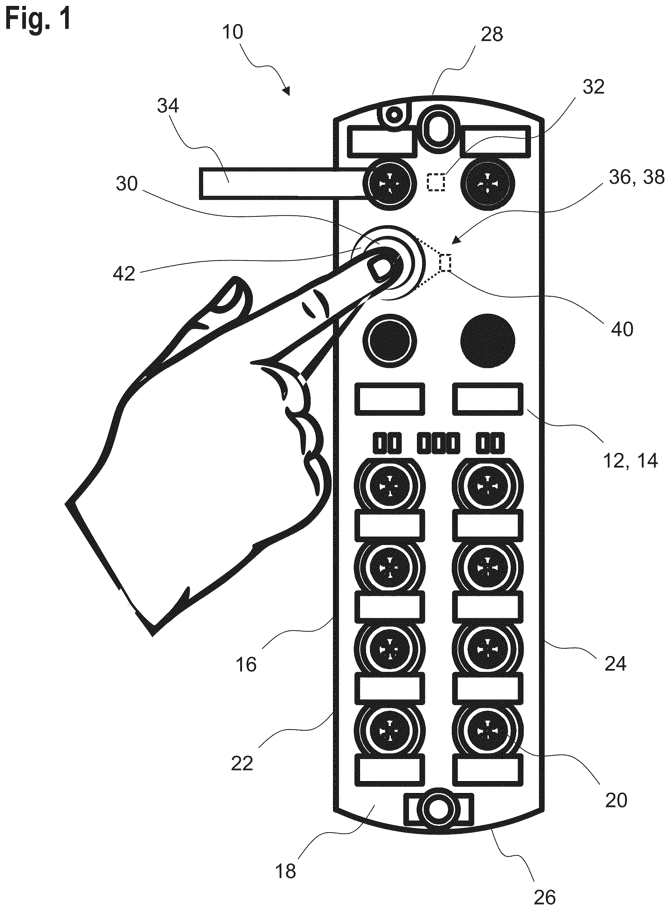

Fig. 1 zeigt ein erfindungsgemäßes Feldgerät 10 gemäß einer ersten beispielhaften Ausführungsform. Das Feldgerät 10 ist als Feldbusmodul ausgebildet und zur Steuerung einer Industrieanlage vorgesehen.

Das Feldgerät 10 umfasst ein Gehäuse 12 mit einer Gehäusewand 14. Das Gehäuse 12 ist beispielsweise durch ein einstückiges Gehäuseteil 16 gebildet, das einen Hohlraum zur Aufnahme elektronischer Komponenten aufweist und durch einen Gehäuseboden verschlossen ist.

Das Feldgerät 10 weist eine Anschlussseite 18 mit einer Mehrzahl an Anschlüssen 20 auf sowie eine erste Längsseite 22, eine zweite Längsseite 24, eine erste Stirnseite 26 und eine zweite Stirnseite 28.

Ferner weist das Feldgerät 10 ein innerhalb des Gehäuses 12 an der Anschlussseite 18 angeordnetes kapazitives Bedienelement 30 auf, mit dem ein Betriebsmodus des Feldgeräts 10 einstellbar ist. Beispielsweise kann das Feldgerät 10 mittels des kapazitiven Bedienelements 30 in einen Werksmodus zurückversetzt werden und/oder ein bestimmter Betriebsmodus mit vorgegebenen Betriebsparametern selektiert werden.

Das kapazitive Bedienelement 30 ist beispielsweise ein Sensor, welcher ein Kondensatorsystem umfasst oder Teil eines Kondensatorsystems bildet. Der Sensor erfasst basierend auf einer Veränderung einer elektrischen Kapazität des Kondensatorsystems eine Eingabe. Zum Beispiel können durch eine Berührung der Gehäusewand 14 und/oder durch eine Bewegung einer Hand eines Nutzers an oder nahe der Stelle der Gehäusewand 14, an welcher das kapazitive Bedienelement 30 angeordnet ist, hervorgerufene Kapazitätsänderungen als Eingaben erfasst werden.

Vereinfacht ausgedrückt ist das kapazitive Bedienelement 30 also betätigbar, indem ein Nutzer seine Hand in dessen Nähe an der Gehäusewand 14 bewegt und dadurch eine Kapazitätsänderung des Kondensatorsystems hervorruft, die dann erfasst und ausgewertet werden kann.

Da das kapazitive Bedienelement 30 bei einer Betrachtung des Gehäuses 12 von außen nicht sichtbar ist, kann optional eine Markierung vorgesehen sein, beispielsweise eine Erhebung, eine Vertiefung oder eine Riffelung in der Gehäusewand 14, welche dem Nutzer anzeigt, wo sich das kapazitive Bedienelement 30 befindet. Ebenso kann ein Aufdruck oder ähnliches am Gehäuse 12 vorgesehen sein.

Neben dem kapazitiven Bedienelement 30 weist das in Fig. 1 gezeigte Feldgerät 10 keine weiteren manuell betätigbaren Bedienelemente auf. Insbesondere ist das Feldgerät 10 frei von mechanischen Schaltern oder Tasten. Dadurch ist das Feldgerät 10 sehr robust ausgebildet.

Ferner weist das Feldgerät 10 einen Prozessor 32 auf, der mit dem kapazitiven Bedienelement 30 gekoppelt ist, und der dazu ausbildet ist, eine Bedienung des kapazitiven Bedienelements 30 nur dann umzusetzen, wenn (zuvor) eine Freigabe erfolgt ist, die auf einem Betätigungsmuster oder einem externen Freigabesignal basiert.

Das externe Freigabesignal ist beispielsweise ein Datensignal und/oder ein Stromsignal, das über eine an einen der Anschlüsse 20 angeschlossene Leitung 34 an das Feldgerät 10 übertragen wird. Alternativ ist selbstverständlich auch eine Übertragung des Freigabesignals an das Feldgerät 10 durch Funk, Wifi, Bluetooth, ZigBee oder eine vergleichbare kabellose Übertragungstechnik denkbar.

In dem in Fig. 1 gezeigten Ausführungsbeispiel ist das kapazitive Bedienelement 30 dazu ausgebildet, eine Einstellung des Betriebsmodus des Feldgeräts 10 nur innerhalb eines vorgegebenen Zeitraums nach einer Inbetriebnahme des Feldgeräts 10 zuzulassen. Der vorgegebene Zeitraum beträgt beispielsweise maximal 15 Minuten, vorzugsweise maximal 1 Minute, besonders bevorzugt maximal 10 Sekunden.

Die Inbetriebnahme erfolgt beispielsweise, indem eine Energieversorgung des Feldgeräts 10 bereitgestellt wird, insbesondere indem das Feldgerät 10 über die Leitung 34 mit einer Energiequelle verbunden wird. Das dabei über die Leitung 34 übertragene Strom- bzw. Energiesignal kann also ein Freigabesignal sein.

Die zeitliche Begrenzung der Einstellung des Betriebsmodus über das kapazitive Bedienelement 30 wird beispielsweise dadurch erreicht, dass das kapazitive Bedienelement 30 nur innerhalb des vorgegebenen Zeitraums nach der Inbetriebnahme mit Energie versorgt wird. Danach ist es inaktiv. Es kann dann nicht mehr versehentlich betätigt werden und verbraucht auch keine elektrische Energie.

Alternativ wird eine Betätigung des (grundsätzlich weiterhin aktiven) kapazitiven Bedienelements 30 nicht weiterverarbeitet, insbesondere vom Prozessor 32.

Das in Fig. 1 gezeigte Feldgerät 10 weist außerdem ein Ausgabeelement 36 zum Ausgeben eines Signals auf, welches dem Nutzer ein Betätigungsmuster zum Betätigen des kapazitiven Bedienelements 30 vorgibt.

Das Ausgabeelement 36 ist beispielsweise ein optischer Signalgeber 38, der dazu ausgebildet ist, das Signal als Lichtsignal an dem Ort auszugeben, an dem das kapazitive Bedienelement 30 angeordnet ist.

In dem in Fig. 1 gezeigten Beispiel umfasst der optische Signalgeber 38 eine innerhalb des Gehäuses 12 angeordnete Lichtquelle 40, die Licht durch einen zumindest teilweise transparenten Bereich 42 des Gehäuses 12 aussenden kann.

Die Lichtquelle 40 wird insbesondere in dem vorgegebenen Zeitraum nach der Inbetriebnahme des Feldgeräts 10 vom Prozessor 32 so angesteuert, dass sie das Lichtsignal mit einem zeitlich variierenden Betätigungsmuster ausgibt. Das Betätigungsmuster weist beispielsweise in ihrer Länge variable abwechselnde An- und Aus-Phasen auf, die dem Nutzer vorgeben, in welchen zeitlichen Abständen und wie lange er das kapazitive Bedienelement 30 betätigen muss, um die Einstellung eines gewünschten Betriebsmodus freizugeben.

Alternativ kann das Ausgabeelement 36 auch einen Lautsprecher umfassen und dazu ausgebildet sein, das Betätigungsmuster in Form von akustischen Signalen auszugeben. Auch eine haptische Ausgabe des Betätigungsmusters ist denkbar, beispielsweise indem das Feldgerät 10 durch das Ausgabeelement 36 in Vibration versetzt wird.

Der Betriebsmodus selbst kann vor oder nach der entsprechenden Freigabe durch eine weitere Betätigung des kapazitiven Bedienelements 30 eingestellt werden. Alternativ kann das Einstellen des gewünschten Betriebsmodus auch durch das Betätigen des kapazitiven Bedienelements 30 mit dem entsprechenden Betätigungsmuster selbst erfolgen.

Ferner ist auch denkbar, dass das kapazitive Bedienelement 30 über eine Datenverbindung aktivierbar und/oder deaktivierbar ist, insbesondere vor einer Inbetriebnahme des Feldgeräts 10. Beispielsweise kann das kapazitive Bedienelement 30 deaktiviert werden, wenn das Feldgerät 10 über einen längeren Zeitraum für dieselbe Anwendung genutzt werden soll und/oder eine Änderung des Betriebsmodus bei dem geplanten Einsatz unerwünscht ist.

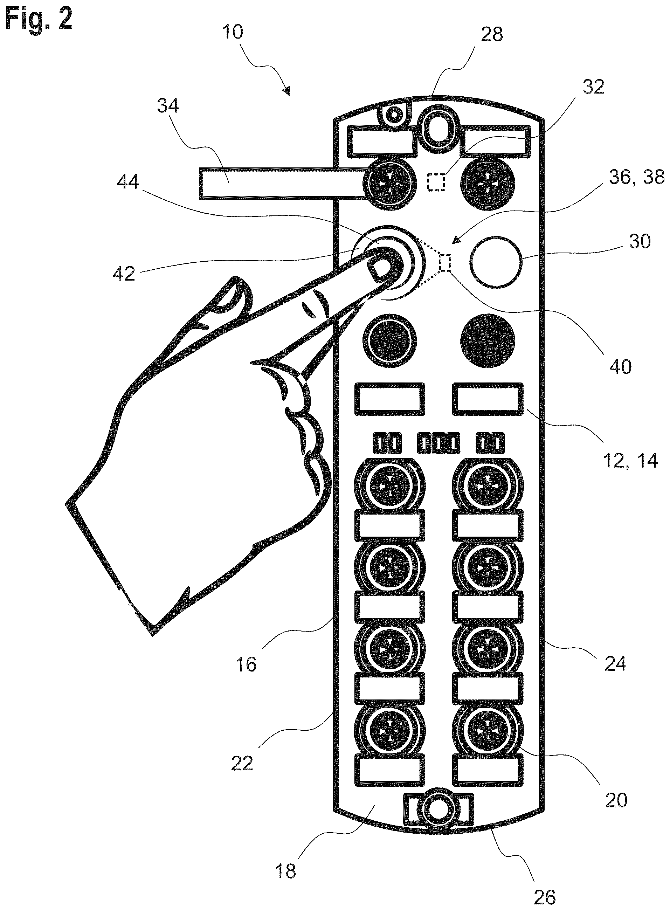

Fig. 2 zeigt ein erfindungsgemäßes Feldgerät 10 gemäß einer zweiten beispielhaften Ausführungsform. Dieses entspricht im Wesentlichen der in Fig. 1 gezeigten ersten Ausführungsform, sodass im Folgenden lediglich auf die Unterschiede eingegangen wird. Gleiche und funktionsgleiche Bauteile sind mit den gleichen Bezugszeichen versehen.

Im Unterschied zur ersten Ausführungsform weist das in Fig. 2 gezeigte Feldgerät 10 ein zusätzliches kapazitives Freigabeelement 44 auf, das dazu ausgebildet ist, das kapazitive Bedienelement 30 freizugeben.

Beispielswiese wird das kapazitive Bedienelement 30 nur dann freigegeben bzw. für eine Eingabe freigeschaltet, wenn zuvor ein bestimmtes Betätigungsmuster durch einen Nutzer am kapazitiven Freigabeelement 44 eingegeben wurde. Das kapazitive Freigabeelement 44 und das kapazitive Bedienelement 30 können durch baugleiche Hardwarekomponenten gebildet sein, die durch den Prozessor 32 unterschiedlich angesteuert werden. Vereinfacht ausgedrückt kann das kapazitive Freigabeelement 44 also ebenfalls ein kapazitives Bedienelement 30 sein.

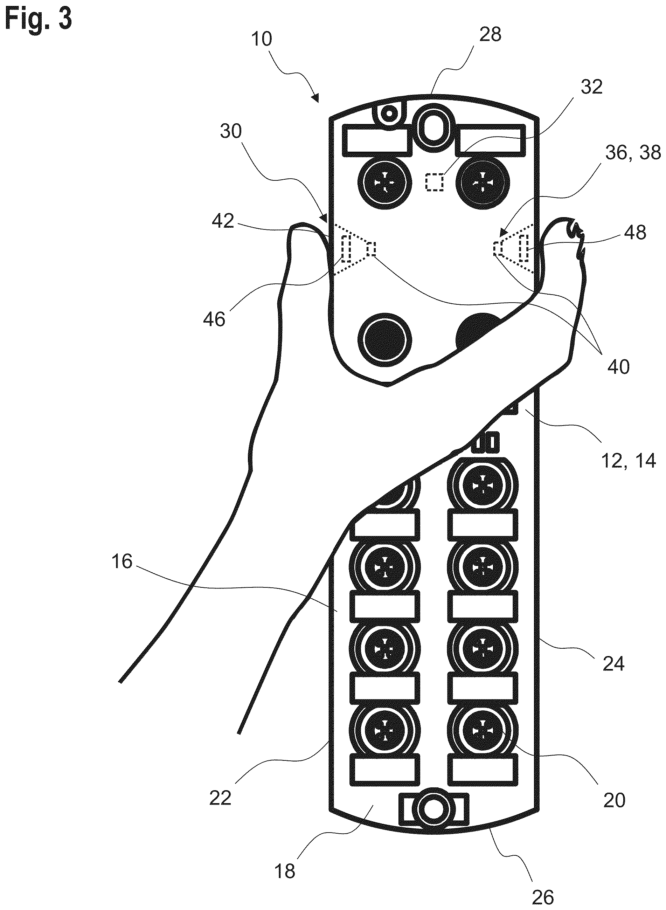

Fig. 3 zeigt ein erfindungsgemäßes Feldgerät 10 gemäß einer dritten beispielhaften Ausführungsform. Dieses entspricht im Wesentlichen den in Fig. 1 und Fig. 2 gezeigten Ausführungsformen, sodass im Folgenden lediglich auf die Unterschiede eingegangen wird. Gleiche und funktionsgleiche Bauteile sind mit den gleichen Bezugszeichen versehen.

Das in Fig. 3 gezeigte Feldgerät 10 weist ein kapazitives Bedienelement 30 auf, welches einen ersten kapazitiven Bereich 46 und einen zweiten kapazitiven Bereich 48 umfasst.

Der erste kapazitive Bereich 46 ist an der ersten Längsseite 22 angeordnet. Der zweite kapazitive Bereich 48 ist an der entgegengesetzten zweiten Längsseite 24 angeordnet.

Der erste und der zweite kapazitive Bereich 46, 48 sind dabei so angeordnet, dass ein Nutzer das Feldgerät 10 mit einer Hand umgreifen und beide kapazitiven Bereiche 46, 48 mit verschiedenen Fingern der Hand erreichen und betätigen kann, insbesondere gleichzeitig.

Das gleichzeitige Berühren des ersten und des zweiten kapazitiven Bereichs 46, 48 kann ein Betätigungsmuster darstellen, mit dem auch gleichzeitig die Bedienung und die Freigabe erfolgt.

Alternativ kann, analog zum ersten Ausführungsbeispiel, mittels eines Ausgabeelements 36, insbesondere eines optischen Signalgebers 38, ein Betätigungsmuster zum Betätigen der beiden kapazitive Bereich 46, 48 vorgegeben werden, das dem Nutzer vorgibt in welchen Abständen und/oder wie lange er die jeweiligen kapazitive Bereiche 46, 48 betätigen muss, um einen gewünschten Betriebsmodus einzustellen und/oder freizugeben.

Das Einstellen des Betriebsmodus erfolgt bei den in Fig .1, Fig. 2 sowie Fig. 3 gezeigten Feldgeräten 10 jeweils mittels eines Ausführungsbeispiels eines erfindungsgemäßen Verfahrens.

In einem ersten Schritt S1 des Verfahrens erfasst der Prozessor 32 eine Freigabe, die aufgrund eines Betätigungsmusters des wenigstens einen kapazitiven Bedienelements 30 oder eines externen Freigabesignals erfolgt.

Bei den in Fig. 1 und Fig. 2 gezeigten Feldgeräten 10 erfolgt die Freigabe beispielsweise durch eine Übermittlung eines Datensignals durch die Leitung 34 an das betreffende Feldgerät 10.

Alternativ oder zusätzlich kann die Freigabe auch erfolgen, indem ein Nutzer das wenigstens eine kapazitive Bedienelement 30 bzw. das kapazitive Freigabeelement 44 in einer definierten zeitlichen Folge betätigt. Diese zeitliche Folge kann fest vorgegeben sein und/oder dem Nutzer durch das Ausgabeelement 36 vorgegeben werden.

Um einen besonders guten Schutz vor unberechtigten Zugriffen zu gewährleisten, kann auch vorgesehen sein, dass das Betätigungsmuster bzw. die zeitliche Folge über eine Datenverbindung, insbesondere über die Leitung 34, an das Feldgerät 10 übermittelt und dann durch das Ausgabeelement 36 ausgegeben wird.

Bei dem in Fig. 3 gezeigten Feldgerät 10 erfolgt die Freigabe alternativ indem ein Nutzer den ersten und den zweiten kapazitiven Bereich 46, 48 gleichzeitig betätigt. Ebenso ist denkbar, dass die Freigabe erfolgt, indem der Nutzer die zwei kapazitiven Bereiche 46, 48 gemäß einer vorgegebenen zeitlichen Abfolge betätigt.

In einem zweiten Schritt S2 des Verfahrens setzt der Prozessor 32 eine Bedienung des kapazitiven Bedienelements 30 um und stellt den gewünschten Betriebsmodus am Feldgerät 10 ein. Die Umsetzung erfolgt nur dann, wenn zuvor in Schritt S1 eine entsprechende Freigabe erfasst worden ist.

Zum Beispiel erfolgt durch die Umsetzung ein Werksreset, mit dem das betreffende Feldgerät 10 in einen ursprünglichen Betriebsmodus zurückversetzt wird.

Dadurch können bereits zuvor in einer Industrieanlage eingesetzte Feldgeräte 10 wiederverwendet werden, insbesondere indem sie bei einer erneuten Inbetriebnahme zurückgesetzt werden.

Auch Störungen können so schnell und einfach behoben werden. Gleichzeitig ist ein hoher Schutz vor unbeabsichtigten Fehleingaben sowie vor Eingaben durch Unberechtigte gegeben.

### Bezugszeichenliste

| Bezugszeichen | Benennung |
|---|---|
| | |
| 10 | Feldgerät |
| 12 | Gehäuse |
| 14 | Gehäusewand |
| 16 | Gehäuseteil |
| 18 | Anschlussseite |
| 20 | Anschluss |
| 22 | erste Längsseite |
| 24 | zweite Längsseite |
| 26 | erste Stirnseite |
| 28 | zweite Stirnseite |
| 30 | kapazitives Bedienelement |
| 32 | Prozessor |
| 34 | Leitung |
| 36 | Ausgabeelement |
| 38 | optischer Signalgeber |
| 40 | Lichtquelle |
| 42 | transparenter Bereich |
| 44 | kapazitives Freigabeelement |
| 46 | erster kapazitiver Bereich |
| 48 | zweiter kapazitiver Bereich |

## Patentansprüche

1. Feldgerät für eine Industrieanlage, umfassend wenigstens ein kapazitives Bedienelement (30), mit dem ein Betriebsmodus des Feldgeräts (10) einstellbar ist, wobei das Feldgerät (10) einen Prozessor (32) aufweist, der mit dem wenigstens einen kapazitiven Bedienelement (30) gekoppelt ist, und wobei der Prozessor (32) eingerichtet ist, eine Bedienung des kapazitiven Bedienelements (30) nur dann umzusetzen, wenn eine Freigabe erfolgt ist, die auf einem Betätigungsmuster oder einem externen Freigabesignal basiert.

2. Feldgerät gemäß Anspruch 1, wobei das wenigstens eine kapazitive Bedienelement (30) zwei kapazitive Bereiche (46, 48) umfasst, die an verschiedenen Seiten des Feldgeräts (10) angeordnet sind.

3. Feldgerät gemäß Anspruch 2, wobei die beiden kapazitiven Bereiche (46, 48) an entgegengesetzten Seiten des Feldgeräts (10) angeordnet sind.

4. Feldgerät gemäß Anspruch 2 oder 3, aufweisend eine Anschlussseite (18), eine erste Längsseite (22), eine zweite Längsseite (24), eine erste Stirnseite (26) und eine zweite Stirnseite (28), wobei einer der beiden kapazitiven Bereiche (46) an der ersten Längsseite (22) des Feldgeräts (10) angeordnet ist und wobei der andere der beiden kapazitiven Bereiche (48) an der zweiten Längsseite (24) des Feldgeräts (10) angeordnet ist.

5. Feldgerät gemäß einem der Ansprüche 2 bis 4, wobei eine gleichzeitige Berührung der beiden kapazitiven Bereiche (46, 48) ein Betätigungsmuster darstellt, womit gleichzeitig die Freigabe und die Bedienung erfolgt.

6. Feldgerät gemäß einem der vorhergehenden Ansprüche, ferner umfassend ein Ausgabeelement (36) zum Ausgeben eines Signals, welches dem Nutzer das Betätigungsmuster vorgibt.

7. Feldgerät gemäß Anspruch 6, wobei das Ausgabeelement (36) ein optischer Signalgeber (38) ist, der dazu ausgebildet ist, ein Lichtsignal an dem Ort auszugeben, an dem das kapazitive Bedienelement (30) angeordnet ist.

8. Feldgerät gemäß Anspruch 6 oder 7, wobei die Freigabe durch eine Bedienung des wenigstens einen kapazitive Bedienelements (30) gemäß dem vom Ausgabeelement (36) ausgegebenen Betätigungsmusters erfolgt.

9. Feldgerät gemäß einem der vorhergehenden Ansprüche, wobei das kapazitive Bedienelement (30) dazu ausgebildet ist, eine Einstellung des Betriebsmodus des Feldgeräts (10) nur innerhalb eines vorgegebenen Zeitraums nach einer Inbetriebnahme des Feldgeräts (10) zuzulassen.

10. Feldgerät gemäß Anspruch 9, wobei der vorgegebene Zeitraum maximal 15 Minuten, vorzugsweise maximal 1 Minute, besonders bevorzugt maximal 10 Sekunden beträgt.

11. Feldgerät gemäß einem der vorhergehenden Ansprüche, ferner aufweisend ein kapazitives Freigabeelement (44), das dazu ausgebildet ist, das kapazitive Bedienelement (30) freizugeben.

12. Feldgerät gemäß einem der vorhergehenden Ansprüche, wobei das Betätigungsmuster eine zeitlich verteilte Eingabe über zumindest einen kapazitiven Bereich (46, 48) des Bedienelements (30) ist.

13. Verfahren zum Einstellen eines Betriebsmodus eines Feldgeräts (10), das wenigstens ein kapazitive Bedienelement (30) aufweist, mit den Schritten:
- Erfassen einer Freigabe, die aufgrund eines Betätigungsmusters des wenigstens einen kapazitiven Bedienelements (30) oder eines externen Freigabesignals erfolgt, und
- Umsetzen einer Bedienung des kapazitiven Bedienelements (30) nur dann, wenn zuvor die Freigabe erfasst worden ist.

14. Verfahren nach Anspruch 13, wobei das Betätigungsmuster eine gleichzeitige Betätigung von wenigstens zwei kapazitiven Bereichen (46, 48) des wenigstens einen kapazitiven Bedienelements (30).

15. Verfahren nach Anspruch 13, wobei das Betätigungsmuster eine Betätigung des wenigstens einen kapazitiven Bedienelements (30) in einer definierten zeitlichen Folge ist.
